# EUROPEAN PATENT APPLICATION

(11) **EP 1 717 952 A1**
(43) Date of publication of application: **02.11.2006**
(21) Application number: 06008774.9
(22) Date of filing: 27.04.2006
(51) Int. Cl.: H03H 9/10, H03H 9/02, H03B 5/32, H03H 9/15

(54) **Piezoelectric resonator and piezoelectric oscillator**

(30) Priority: 28.04.2005 JP 2005133548
(71) Applicant: Epson Toyocom Corporation, Saiwai-ku Kawasaki-shi Kanagawa 212-8513 (JP)
(72) Inventor: Tanaka, Yoshiaki, Kamiina-gun Nagano-ken 399-4696 (JP)
(74) Representative: HOFFMANN EITLE

(57) **Abstract**

A piezoelectric resonator comprises: an insulating package provided with a concave portion at a lower region thereof; an piezoelectric resonator installed within the concave portion of the insulating package; a lid sealing a lower opening of the concave portion; and a metal lead terminal of which a upper region is electromechanically connected and fixed to the outer terminal installed at the outer surface of the insulating package, and a lower region thereof is projected downward from the lid. The metal lead terminal includes a drooping portion extending along the side surface of the insulating package and a connecting member extending from the lower part of the drooping portion. The drooping portion is not constrained from the connecting member, and the drooping portion and the connecting member are capable of elastically deformed.

## Description

### BACKGROUND OF THE INVENTION

### 1.Technical Field

The present invention relates to improving a surface -mounting electronic device such as a piezoelectric resonator and a piezoelectric oscillator. In particular, it relates to a surface -mounting electronic device using lead members like J leads as terminals for connection.

### 2. Related Art

In mobile telecommunication device market, major manufactures promote modular designing of parts groups for each function, in considering commonality of parts among devices regarding packaging, maintenance and handling.

Further, down sizing as well as low manufacturing cost is strongly required accompanied with promoting modular designing.

In particular, promoting modular designing is enhanced in the area of electronic parts such as standard oscillators, PLL circuits, and synthesizers where hardware and functions are already established and high stability and high performance are required. Furthermore, packaging these parts group as a module has advantage that a shield structure is easily formed.

For example, piezoelectric resonators, piezoelectric oscillators and SAW devices are cited as examples of surface -mounting electronic devices formed by putting a plurality of related parts into a module or packaging them.

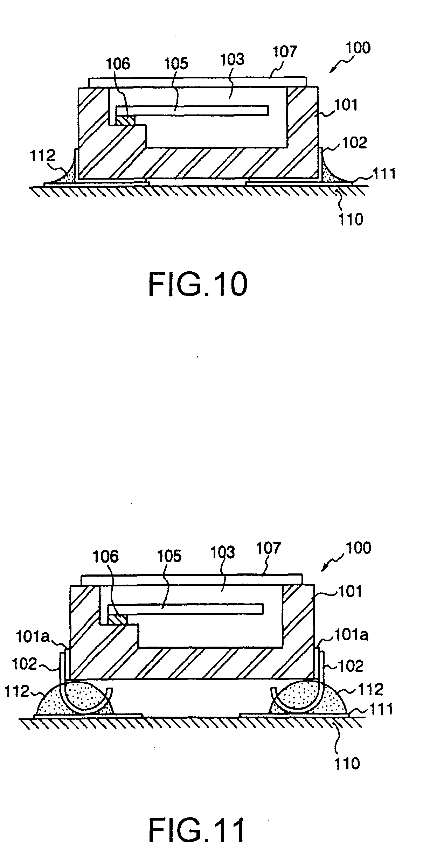

Fig. 10 is a cross section of a structure of the conventional surface -mounting quartz resonator.

As shown in Fig. 10, a quartz resonator 100 comprises a ceramic package 101, a mounting terminal 102, a quartz resonating element 105, connecting member 106 and a lid 107. The mounting terminal 102 is a plane shaped configuration for surface mounting the quartz element 105. The resonating quartz element 105 has a structure in which exciting electrodes and others are formed on a quartz substrate and is mounted on a connecting pad within a concave portion 103 in the ceramic package 101. Further it is fixed by the connecting member 106 composed of conductive adhesives. The concave portion 103 of the ceramic package 101 is sealed by the lid 103 made of a metal.

As shown in the figure, the quartz resonator 100 is fixed on a printed circuited board 110 by connecting the mounting terminal 102 to a land 111 on the printed circuited board 110 with a solder 112.

Fig. 11 is a sectional view showing a structure of the other conventional surface -mounting quartz resonator (See JP-A- 2000-12997).

The same reference numerals in Fig. 10 are applied to the same parts. The difference from the quartz resonator in Fig. 10 is that the mounting terminal 102 having a plane shape is replaced with a J lead terminal 102 having a J shape made of a metal. The J lead terminal 102 is fixed with a brazing filler metal to a connecting pad 101a installed around the external circumference of the ceramic package 101.

In these other conventional surface -mounting quartz resonators, however, a stress is greatly applied to the solder 112. This stress is caused by thermal expanding difference between the ceramic package 101 and the printed circuit board composed of a glass epoxy and the like. The stress easily yields cracks in the solder connection.

Further, even in the quartz resonator shown in Fig. 11, the length of the J lead terminal 102 should be shortened accompanied with the down sizing, insufficiently securing spring function of the J lead terminal 102. This problem further causes insufficient relaxation of the stress due to thermal expanding difference between the printed circuit board and the terminal.

### SUMMARY

In view of the above problems, the advantage of the present invention is to provide a surface mounting electronic device with a lead, which can prevent a solder connection from breaking down due to thermal expanding difference between a printed circuit board and a ceramic package. The surface mounting electronic device is provided with a surface mounting electronic part in which a terminal for mounting is installed at the bottom of an insulating package such as ceramic package. Further, a J lead terminal is used to mount the part on a printed circuit board with satisfying the request of low height of a part and sufficiently maintaining the spring effect of the J lead.

According to a first aspect of the invention, a piezoelectric resonator comprises: an insulating package provided with a concave portion at a lower region; an piezoelectric resonator element installed within the concave portion of the insulating package; a lid sealing a lower opening of the concave portion; and; a metal lead terminal of which a upper region is electromechanically connected and fixed to an outer terminal installed at the circumference of the insulating package, and a lower region is protruded downward from the lid. The metal lead terminal includes a drooping portion extending along the side of the insulating package and a connecting member extending from the lower part of the drooping portion. The drooping portion is not constrained from the connecting member, and the drooping portion and the connecting member are capable of elastically deformed.

In the first aspect of the invention, the upper end of the metal lead terminal may be electromechanically connected and fixed to the outer terminal installed at the upper area or the side area of the insulating package.

In the first aspect of the invention, the entire outer surface of the insulating package may be covered with a resin.

In the first aspect of the invention, the metal lead terminal may be a J lead terminal of which the connecting member is curved.

According to a first aspect of a piezoelectric oscillator of the invention, it comprises: a piezoelectric resonator including: an insulating package provided with a concave portion at a lower region; a piezoelectric resonator installed within the concave portion of the insulating package; a lid sealing a lower opening of the concave portion; a metal lead terminal of which a upper region is electromechanically connected and fixed to the an outer terminal installed at the circumference of the insulating package, a lower region is protruded downward from the lid; an IC chip face-down bonded to the upper surface of the piezoelectric resonator. The metal lead terminal includes a drooping portion extending along the side of the insulating package and a connecting member extending from the lower part of the drooping portion. The drooping portion is not constrained from the connecting member, and the drooping portion and the connecting member are capable of elastically deformed.

In the first aspect of the piezoelectric oscillator of the invention, an external terminal installed at the upper surface of the piezoelectric resonator may be connected to the upper end of the metal lead terminal and the IC chip may be mounted on the upper end of the metal lead terminal via a connecting member.

In the first aspect of the piezoelectric oscillator of the invention, the IC chip may be face-down bonded to the external terminal installed at the upper surface of the piezoelectric resonator via connecting member and at least a part of the connecting member may be placed in a rear surface area of a sealing frame of the insulating package.

In the first aspect of the piezoelectric oscillator of the invention, an external terminal installed at the side surface of the piezoelectric resonator may be connected to the upper portion of the metal lead terminal and the IC chip may be face-down bonded to the external terminal installed on the upper surface of the piezoelectric resonator via the connecting member.

In the first aspect of the piezoelectric oscillator of the invention, an external terminal installed at the side surface of the piezoelectric resonator may be connected to the upper portion of the metal lead terminal and the IC chip may be face-down bonded to the external terminal installed on the upper surface of the piezoelectric resonator via the connecting member and at least a part of the connecting member may be placed in a rear surface area of a sealing frame of the insulating package.

In the first aspect of the piezoelectric oscillator of the invention, the entire outer surface of the IC chip may be covered with a resin.

In the first aspect of the piezoelectric oscillator of the invention, the side surface and the upper surface of the IC chip may be exposed without being covered with a resin.

In the first aspect of the piezoelectric oscillator of the invention, an under- fill material may be filled between the upper surface of the insulating package and the lower surface of the IC chip.

In the first aspect of the piezoelectric oscillator of the invention, the outer surface of the quartz resonator may be covered with a resin and an under- fill material may be filled in the inside of a dam, in which the upper circumference of the resin covered film is protruded as a circularly-arranged form.

In the first aspect of the piezoelectric oscillator of the invention, an upper portion of the metal lead terminal for connecting to the ground is fixed to the upper surface of the piezoelectric resonator which is a circularly-arranged and an under- fill material may be filled in the a circularly-arranged region.

In the first aspect of a piezoelectric resonator of the invention, the metal lead terminal, of which upper portion is fixed to the insulating package, includes a drooping portion extending along the side of the insulating package and a connecting member extending from the lower part of the drooping portion. Further, the drooping portion is not constrained from the connecting member, and the drooping portion and the connecting member are capable of elastically deformed.

This structure secures the wide range of available stroke caused by the deflection of a metal material since the metal lead terminal of the invention, which is elastically deformed, is longer compared to the conventional lead terminal.

Further, such longer metal lead terminal easily relaxes a stress with its spring function. This stress is caused by thermal expanding difference between the printed circuit board and the piezoelectric resonator (the ceramic package) formed on the printed circuit board.

In the first aspect of the piezoelectric resonator of the invention, the upper end of the metal lead terminal may be electromechanically connected and fixed to the outer terminal installed at the upper area or the side area of the insulating package. This structure makes an intermediated portion of the metal lead terminal (the drooping portion) and lower portion be free, resulting in the above effect.

In the first aspect of the piezoelectric resonator of the invention, the entire outer surface of the insulating package may be covered with a resin, shielding the package against bad influences of atmosphere.

In the first aspect of the piezoelectric resonator of the invention, the metal lead terminal may be a J lead terminal of which the connecting member is curved, effectively utilizing a spring function.

In the first aspect of the piezoelectric oscillator of the invention, the piezoelectric oscillator shows effects described above in the piezoelectric resonator of the invention.

In the first aspect of the piezoelectric oscillator of the invention, an external terminal installed at the upper surface of the piezoelectric resonator may be connected to the upper end of the metal lead terminal and the IC chip may be mounted on the upper end of the metal lead terminal via a connecting member.

This structure also shows effects described above in the piezoelectric oscillator of the invention.

In the first aspect of the piezoelectric oscillator of the invention, an under- fill material can be effectively filled between the insulating package and the IC chip.

In the first aspect of the piezoelectric oscillator of the invention, the upper portion of the J lead terminal is not existed between the insulating package and the IC chip, taking advantage for lowering the height of the oscillator.

In the first aspect of the piezoelectric oscillator of the invention, the entire outer surface of the IC chip may be covered with a resin, shielding the IC chip against bad influences of atmosphere.

In the first aspect of the piezoelectric oscillator of the invention, , the side surface and the upper surface of the IC chip may be exposed without being covered with a resin, simplifying manufacturing process and downsizing the oscillator.

In the first aspect of the piezoelectric oscillator of the invention, an under- fill material can be effectively filled between the upper surface of the insulating package and the lower surface of the IC chip, enhancing connecting strength between them.

In the first aspect of the piezoelectric oscillator of the invention, the outer surface of the quartz resonator may be covered with a resin and an under- fill material may be filled in the inside of a dam, in which the upper circumference of the resin covered film is protruded as a circularly-arranged form, promoting efficient job for filling the under- fill material.

### BRIEF DESCRIPTION OF THE DRAWINGS

The invention will be described with reference to the accompanying drawings, wherein like numbers reference like elements.

Fig. 1 A is an outer perspective view of a quartz resonator (a piezoelectric oscillator) as a surface mounting electronic device of the first embodiment of the invention and Fig.1B is a cross section of it.

Fig.2 A is an outer perspective view of a quartz resonator (a piezoelectric oscillator) as an surface mounting electronic device of the first embodiment of the invention and Fig.2B is a cross section of it.

Fig 3A shows a modification of the quartz resonator in Fig.1A and Fig 3B shows a modification of the quartz resonator in Fig.2A.

Fig.4 A is an outer perspective view of an surface mounting quartz oscillator (a piezoelectric oscillator) of the embodiment of the invention and Fig.4B is a cross section of it.

Figs. 5A to 5C are cross sections showing modifications of the quartz oscillator shown in Fig.4A and 4B.

Fig.6A is an outer perspective view of a quartz oscillator of the other embodiment of the invention and Fig.6B is a cross section of it.

Figs.7A and 7B show modification of the quartz oscillator shown in Figs.6A and 6B.

Figs.8A and 8B shows modification of the quartz oscillator shown in Figs.7A and 7B.

Fig.9 shows the other embodiment.

Fig. 10 is a cross section of the first conventional quartz resonator.

Fig.11 is a cross section of the second conventional quartz resonator.

### DESCRIPTION OF THE OF EXEMPLARY EMBODIMENTS

The embodiments of the invention are explained referring with figures.

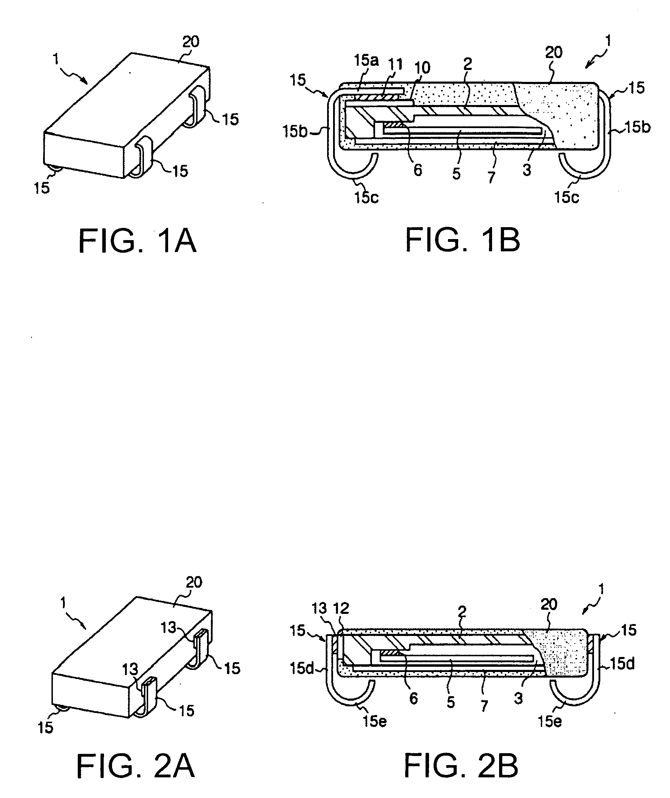

Fig. 1 A is an outer perspective view of a quartz resonator (a piezoelectric oscillator) as a surface mounting electronic device of the first embodiment of the invention and Fig. 1B is a cross section of it.

A quartz resonator 1 comprises a ceramic package 2, a quartz resonating element 5, a connecting member 6 and a lid 7. The resonating quartz element 5 has a structure in which exciting electrodes and others are formed on a quartz substrate and is mounted on a connecting pad not shown in the figure within a concave portion 103 in the ceramic package 101.

Further it is fixed by the connecting member 106 composed of conductive adhesives. The concave portion 3 is sealed by the lid 7 made of a metal. Further, a plurality of metalized upper terminals (external terminals) 10 is formed on the upper surface of the ceramic package 2. The upper terminal 10 is fixed and connected to a mounting terminal 15 composed of a metal lead terminal via a brazing filler metal 11. At least two upper terminals 10 are electrically connected to the internal pad not shown in the figure within the ceramic package via the internal conductive member not shown in the figure.

A metal lead terminal constituting the mounting terminal 15 has a J lead configuration, for example. The J lead terminal 15 comprises an upper portion 15a, a drooping portion 15b and a connecting member 15c. The lower surface of the upper portion 15a, which is horizontally extending, is connected to the upper terminal 10 and the side end of the upper portion 15a is protruded toward the outer side of the ceramic package and then bent toward downward. The lower part of the drooping portion 15b bent toward downward is curved toward the inside of the package to be the connecting potion 15c.

Further, the outer surface of the ceramic package is covered with a mold resin 20 except the drooping portion 15b and the connecting member 15c, preventing the connecting member 15c which is the end of the J lead terminal, from clashing and contacting with the lid 7. The movement of the drooping portion 15b and the connecting member 15c is not constrained by the mold resin 20, freely elastically deforming and performing as a spring effect.

The quartz resonator 1 is fixed on the printed circuit board by connecting the J lead terminal (a mounting terminal) 15 to the land of the printed circuit board with solder so that the lid 7 is placed on the side of the printed circuit board. This structure secures the wide range of available stroke caused by the deflection of a metal material since the metal lead portions 15b and 15c, which are elastically deformed, are longer compared to the J lead terminal shown in Fig. 11. Further, such longer metal lead terminal easily relaxes a stress with its spring function. This stress is caused by thermal expanding difference between the printed circuit board and the piezoelectric resonator (the ceramic package) formed on the printed circuit board.

Next, Fig.2A is an outer perspective view of a quartz resonator (a piezoelectric oscillator) as a surface mounting electronic device of a second embodiment of the invention and Fig.2B is a cross section of it.

The difference between the first embodiment shown in Fig.1 and the second embodiment shown in Fig.2 is that the J lead terminal 15 is fixed and connected to the side terminal (an external terminal) 12 installed on the side surface of the ceramic package 2 with a brazing filler metal 13. The side terminal 12 is connected to a connecting pad within the concave portion 3 connected to the electrode on the quartz resonating element 5 via an internal conductive member not shown in the figure.

The J lead terminal 15 comprises the base 15d extending upward and downward, and the connecting member 15e in which the lower part of the base 15d is curved into the inside of the ceramic case. The base 15d is fixed and connected to the side terminal 12 with a brazing filler metal 13.

The quartz resonator 1 is fixed on the printed circuit board by connecting the J lead terminal (a mounting terminal) 15 to the land of the printed circuit board with solder so that the lid 7 is placed on the side of the printed circuit board.

This structure secures the wide range of available stroke caused by the deflection of a metal material since the metal lead portions 15'd and 15'e (the area for the thickness of the lid 7 and the clearance to avoid electrical conduction between the lid 7 and the brazing filler metal 13), which is elastically deformed, is longer compared to the J lead terminal shown in Fig. 11.

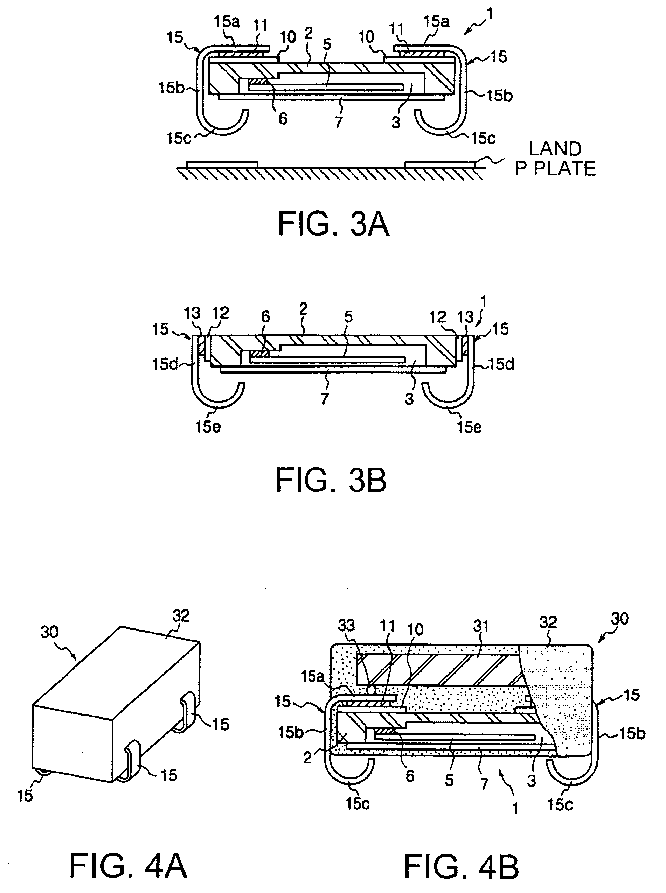

Further, such longer metal lead terminal easily relaxes a stress with its spring function. This stress is caused by thermal expanding difference between the printed circuit board and the quartz resonator (the ceramic package) mounted on the printed circuit board. Here, in quartz resonators shown in Fig.1 and Fig.2, the outer surface of the package is covered with a mold resin. But, as shown in Figs.3A and 3B, the surface may not be covered with a mold resin if the J lead is certainly not contact with the lid.

Namely, the structure shown in Fig.3A is a modification of the quartz resonator shown in Fig.1, and substantially the same except that there is no covered film such mold resin 20.

Further, the structure shown in Fig.3B is a modification of the quartz resonator shown in Fig.2, and substantially the same except that there no cover film such mold resin 20.

Next, Fig.4 A is an outer perspective view of a surface mounting quartz oscillator (a piezoelectric oscillator) of the embodiment of the invention and Fig.4B is a cross section of it.

A quartz oscillator 30 comprises the quartz resonator 1 shown in Fig.3A, an IC chip 31, a ceramic package and a mold resin 32. The IC chip comprising electronic circuits such as an amplifier and a temperature compensation circuit is mounted above the quartz resonator 1 and the mold resin 32 is covered over the outer surface of the ceramic package and the IC chip.

In this case, the J lead terminal 15 functions as the output terminal of an oscillator, the ground terminal, the power source terminal and the terminal for automatic frequency control (AFC), fore example.

The IC chip 31 is face-down bonded to be fixed and electrically connected to the upper portion 15a of the J lead terminal 15 via a connecting member 33 such as a bump. Namely, the outer electrode of the IC chip 31 is faced downward and the connecting member 33 is connected to the outer terminal and the upper portion 15a of the J lead terminal. Then, the entire outer surface except the drooping portion 15b and the connecting member 15c of the J lead terminal 15 is covered with a resin 32. The resin 32 is also filled in the space between the upper surface of the ceramic package 2 and the lower surface of the IC chip 31.

Namely, according to the quartz oscillator of the embodiment, the outer surfaces of the ceramic package and the IC chip are covered with a mold resin 32 except the drooping portion 15b and the connecting member 15c, preventing the connecting member 15c which is the end of the J lead terminal, from clashing and contacting with the lid 7. The movement of the drooping portion 15b and the connecting member 15c is not constrained by the mold resin 32, freely elastically deforming.

The quartz oscillator 30 is fixed on the printed circuit board by connecting the J lead terminal (a mounting terminal) 15 to the land of the printed circuit board with solder so that the lid 7 is placed on the side of the printed circuit board.

This structure secures the wide range of available stroke caused by the deflection of a metal material since the metal lead portions 15b and 15c, which are elastically deformed, are longer compared to the J lead terminal shown in Fig. 11. Further, such longer metal lead terminal easily relaxes a stress with its spring function. This stress is caused by thermal expanding difference between the printed circuit board and the quartz oscillator (the ceramic package) mounted on the printed circuit board. Namely, in order to transmit a shock from the printer circuit board mounting the quartz oscillator to the IC chip, it is necessary that the shock energy tracks the curved pass of the J lead terminal. Hence, this energy is attenuated on the way of transmission. As the result, the break down of the IC chip can be avoided. This effect is similar to the following embodiment of the quartz oscillator (the piezoelectric oscillator).

According to this structure, sufficient shielding can be attained even a shield case is not provided on the upper surface of the IC chip for the oscillator exclusive, since the semiconductor constituting the IC is a ground level.

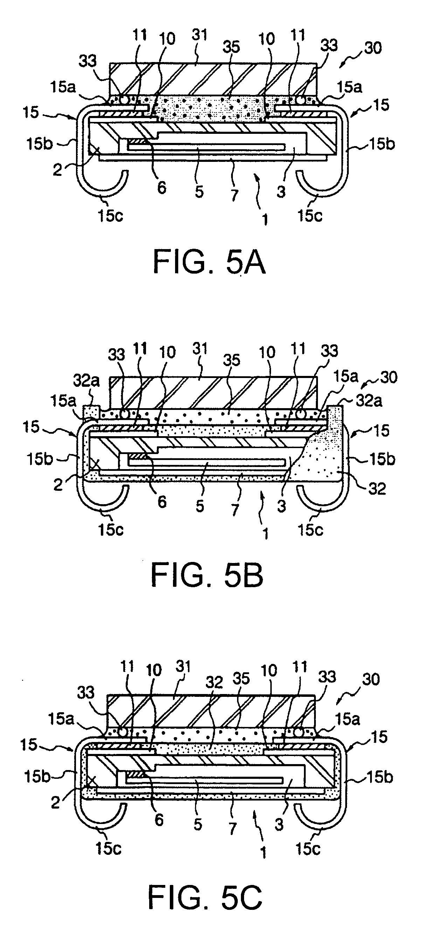

Next, Figs. 5A to 5C are cross sections showing modifications of the quartz oscillator shown in Fig.4A and 4B.

According to Fig.5A, in the quartz oscillator 30, an adhesive resin(an under fill material) 35 is filled between the lower surface of the IC chip 31 and the upper surface of the ceramic package 2 instead that the mold resin 32 is coated there as shown in Fig.4. In this quartz oscillator of the embodiment, the mold resin 32 is not existed, improving productivity with simplifying a manufacturing process and downsizing the quartz oscillator compared to the structure shown in Fig.4. Further, in the quartz oscillator 30 shown in Fig.5B, most entire outer surface of the ceramic package 2 is covered with the mold resin 32 except the upper portion 15a of the J lead terminal 15. A circular dam 32a made of the mold resin is formed along the circumference of the ceramic package 2. Further, the IC chip is face-down bonded to the upper end portion of the J lead terminal via the connecting member 33. Then, the under fill material 35 is filled in the concave region within the circular dam 32a. According to this structure, an under- fill material can be effectively filled between the insulating package and the IC chip.

In the quartz oscillator 30 shown in Fig.5C, the IC chip 31 is face-down bonded to the upper end portion of the J lead terminal of the mold- coated quartz resonator 1 and the under fill material 35 is filled between the quartz resonator 1 and the IC chip 31.

The difference between the quartz oscillators 30 shown in Fgs.5B and 5C, is that there is no circular dam 32a in Fig.5C.

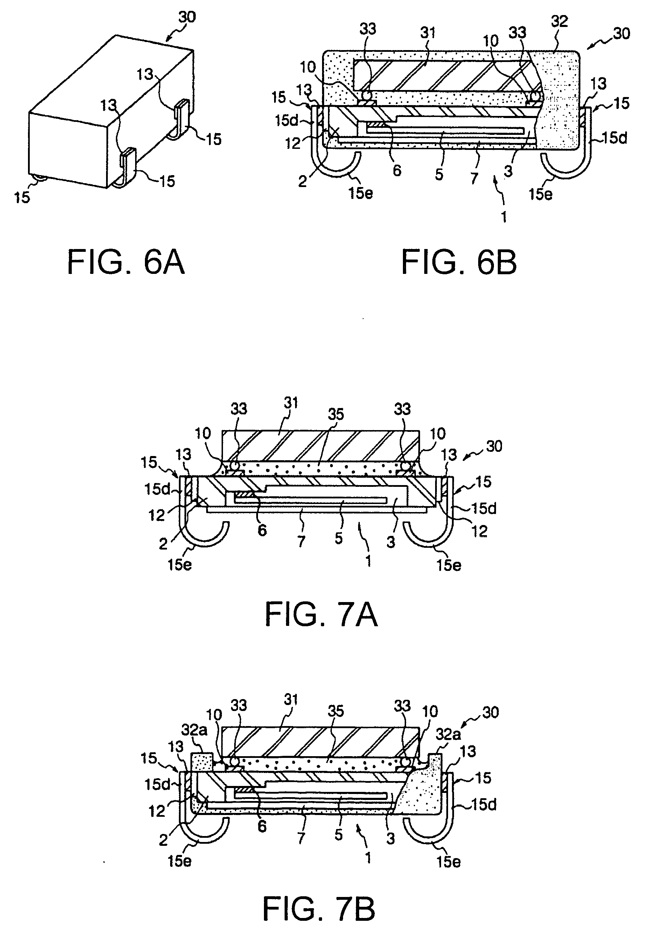

Fig.6A is an outer perspective view of a quartz oscillator of the other embodiment of the invention and Fig.6B is a cross section of it.

In the quartz oscillator shown in Figs.6A and 6B, an metalized upper land (an external terminal) 10 is placed on the upper surface of the ceramic package 2 of the quartz oscillator 1 shown in Fig.3B. Further, the electrode of the face down boded IC chip 31 is connected to the upper land 10 via the connecting member 33 such as a bump, and the entire outer surfaces of the ceramic package 2 and the IC chip 31 are covered by the mold resin 32 except the J-lead terminal 15.

This structure has an advantage in lowering the height of the quartz oscillator comparing with the quartz oscillator shown in Figs.4 and 5, since the upper portion 15a of the J-lead terminal 15 is not existed between the IC chip 31 and the ceramic package 2.

In order to transmit a shock from the printer circuit board mounting the quartz oscillator to the IC chip, it is necessary that the shock energy tracks the curved pass of the J lead terminal. Hence, this energy is attenuated on the way of transmission. As the result, breaking down the IC chip can be avoided. This effect is similar to the following embodiment of the quartz oscillator (the piezoelectric oscillator.)

Figs.7A and 7B show modifications of the quartz oscillator shown in Figs.6A and 6B. According to Fig.7A, in the quartz oscillator 30, the adhesive resin(an under fill material) 35 is filled between the lower surface of the IC chip 31 and the upper surface of the ceramic package 2 instead that the mold resin 32 is coated there as shown in Fig.6. In this quartz oscillator of the embodiment, the mold resin 32 is not existed, improving productivity with simplifying a manufacturing process and downsizing the quartz oscillator compared to the structure shown in Fig.6.

According to Fig.7B, the entire outer surface of the ceramic package except the upper circumference of the package is covered with the mold resin 32. Further, the circular dam (dam portion) 32a made of a mold resin is formed and projected along the outer circumference of the ceramic package 2. Further, the IC chip 31 is face-down bonded to the upper land (external terminal) 10 via the connecting member 33. Then, the under fill material 35 is filled in the concave region within the circular dam 32a. According to this structure, an under- fill material can be effectively filled between the insulating package and the IC chip.

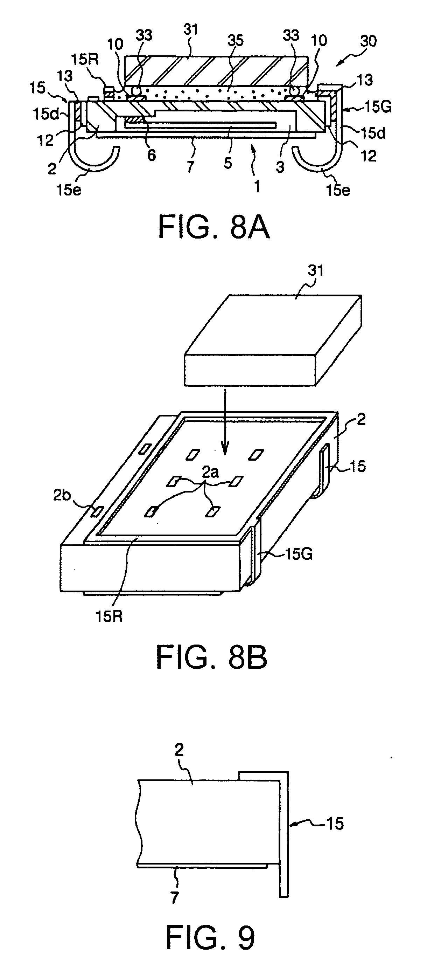

Figs.8A and 8B show modifications of the quartz oscillator shown in Fig.7A and 7B. Fig.8A is a cross section showing a quartz oscillator in which a circular dam for under fill is formed and integrated with the J lead and Fig.8B is a disassembled perspective view of it.

Namely , among J lead terminals 15 which are installed in the side surface of the ceramic package 2, a circular frame 15R is installed only on the upper portion of the J lead terminal 15 which is a ground terminal for example. Further, the circular frame 15R is firmly fixed to the surface of the ceramic package 2 with a brazing filler metal.

Then, the IC chip 31 is face-down bonded to the upper land 10 surrounded by the circular frame.

The under fill material 35 is coated or filled within the circular frame 15R before or after the IC chip is mounted.

Here, it is desirable that an IC arrangement terminal 2b is provided outside of the circular frame, when an terminal for inputting data is needed for arranging circuit conditions of the IC chip.

Further, the loss of ultrasonic energy applied to the IC chip 31 when flip-chip mounting it, becomes large if the connecting member shown in Fig.6 to Fig.8 is mounted on a thin area of the ceramic package 2. Hence, it is preferable that the area having thicker thickness of the ceramic package 2 be selected. More preferably, at least a part of the connecting member 33 is placed to be easily connected to the back area of the circumferential frame (a sealing frame) of the ceramic package 2.

Further, in the above embodiment, the metal lead is a J lead metal having a curved portion as a J shape. But, the end part of the metal lead toward the lid side is not necessarily bent, may be straight line instead as shown in Fig.9.

This structure has an advantage in that an the height of electronic part can be lowered since there is no need of bending the lead terminal. Further, as shown in Fig.5, Fig.7 and Fig.8, the IC chip 31 was face-down bonded, minimizing the range of covering the IC chip with a resin. This effect is due to the fact that the entire surface of the IC chip is not necessarily covered with a resin like an IC for wire bonding to protect a bonding wire.

The above embodiments related to a quartz resonator and a quartz oscillator using a quartz resonator element as a piezoelectric resonator element. But, the present invention may be also applied to a quartz resonator and a quartz oscillator using a piezoelectric resonator element using a piezoelectric material except quartz.

## Claims

1. A piezoelectric resonator comprising:
an insulating package provided with a concave portion at a lower region thereof;
an piezoelectric resonator element installed within the concave portion of the insulating package ;
a lid sealing a lower opening of the concave portion; and
a metal lead terminal of which a upper region is electromechanically connected and fixed to the outer terminal installed at the outer surface of the insulating package, and a lower region thereof is projected downward from the lid,
wherein the metal lead terminal includes a drooping portion extending along the side surface of the insulating package and a connecting member extending from the lower part of the drooping portion,
wherein the drooping portion is not constrained from the connecting member, and the drooping portion and the connecting member are capable of elastically deformed.

2. The piezoelectric resonator according to claim 1, wherein the upper end of the metal lead terminal is electromechanically connected and fixed to the outer terminal installed at the upper surface or the side surface of the insulating package.

3. The piezoelectric resonator according to claim 1 or 2, wherein the entire outer surface of the insulating package is covered with a resin.

4. The piezoelectric resonator according to claim 1, 2 or 3 wherein the metal lead terminal is a J lead terminal of which the connecting member is curved

5. A piezoelectric oscillator comprising:
an insulating package provided with a concave portion at a lower region;
an piezoelectric resonator installed within the concave portion of the insulating package ;
a lid sealing a lower opening of the concave portion; ;
a metal lead terminal of which a upper region is electromechanically connected and fixed to the an outer terminal installed at the circumference of the insulating package, and a lower region is protruded downward from the lid; and
an IC chip face-down bonded to the upper surface of the piezoelectric resonator,
wherein the metal lead terminal includes a drooping portion extending along the side surface of the insulating package and a connecting portion extending from the lower part of the drooping portion,
wherein the drooping portion is not constrained from the connecting portion, and the drooping portion and the connecting portion are capable of elastically deformed.

6. The piezoelectric resonator according to claim 5, wherein an external terminal installed at the upper surface of the piezoelectric resonator is connected to the upper end of the metal lead terminal and the IC chip is mounted on the upper end of the metal lead terminal via a connecting unit.

7. The piezoelectric oscillator according to claim 5, wherein the IC chip is face-down bonded to the external terminal installed at the upper surface of the piezoelectric resonator via connecting member and at least a part of the connecting member is placed in a rear surface area of a sealing frame of the insulating package.

8. The piezoelectric oscillator according to claim 5, wherein an external terminal installed at the side surface of the piezoelectric resonator is connected to the upper end of the metal lead terminal and the IC chip is face-down bonded to the external terminal mounted on the upper surface of the piezoelectric resonator via the connecting member.

9. The piezoelectric resonator according to claim 5, wherein an external terminal installed at the side surface of the piezoelectric resonator is connected to the upper portion of the metal lead terminal and the IC chip is face-down bonded to the external terminal installed on the upper surface of the piezoelectric resonator via the connecting member and at least a part of the connecting unit is placed in a rear surface area of a sealing frame of the insulating package.

10. The piezoelectric resonator according to any one of the preceding claims 5 to 9, wherein the entire outer surface of the IC chip is covered with a resin.

11. The piezoelectric resonator according to any one of the preceding claims 5 to 9, wherein the side and upper surfaces of the IC chip are exposed without being covered with a resin.

12. The piezoelectric resonator according to any one of the preceding claims 5 to 11, wherein an under- fill material is filled between the upper surface of the insulating package and the lower surface of the IC chip.

13. The piezoelectric resonator according to any one of the preceding claims 5 to 12, wherein the outer surface of the quartz resonator is covered with a resin and an under- fill material is filled in the inside of a dam, in which the upper circumference of the resin covered film is protruded as a circularly-arranged form.

14. The piezoelectric resonator according to any one of the preceding claims 8 and 10 to 13, wherein an upper portion of the metal lead terminal for connecting to the ground is fixed to the upper surface of the piezoelectric resonator, which is a circularly-arranged and an under- fill material is filled in the circularly-arranged region.
